# EUROPÄISCHE PATENTSCHRIFT

(11) **EP 1 453 365 B1**
(45) Veröffentlichungstag und Bekanntmachung des Hinweises auf die Patenterteilung: **28.06.2006**
(21) Anmeldenummer: 04013307.6
(22) Anmeldetag: 13.12.1999
(51) Int. Cl.: H05K 7/14

(54) **Steckbaugruppe mit Aktiv-Passiv-Schaltung und Ein- und Aushebegriff für eine derartige Steckbaugruppe**
Plug-in unit with active/passive switching and lever for insertion and removal of such plug-in unit
Unitè enfichable avec dispositif d' activation et de déactivation et dispositif pour insérer ou extraire une telle unité

(30) Priorität: 28.12.1998 DE 29823122 U; 17.03.1999 EP 99810234
(43) Veröffentlichungstag der Anmeldung: 01.09.2004
(62) Teilanmeldung aus: 99811150.4
(73) Patentinhaber: ELMA Electronic AG, 8620 Wetzikon (CH)
(72) Erfinder: Ulrich, Daniele, 8624 Grüt (CH)
(74) Vertreter: Sulzer Management AG

(56) Entgegenhaltungen:
- EP-A- 0 587 451
- US-A- 5 309 325
- US-A- 5 321 962
- "LATCHES FOR EQUIPMENT DRAWERS" 1. September 1992 (1992-09-01), NTIS TECH NOTES, US DEPARTMENT OF COMMERCE. SPRINGFIELD, VA, US, PAGE(S) 671 , XP000322552 ISSN: 0889-8464 * das ganze Dokument *

## Beschreibung

Die Erfindung handelt von einem Baugruppenträger mit einer Steckbaugruppe, welche mittels Führungen in einem Gehäuse einführbar ist und welche mit mindestens einem Ein- und Aushebegriff in Form eines auf einer Achse gelagerten Hebels an ihrer Frontseite versehen ist, um durch Abstützen an einem frontseitigen Gehäuseprofil Einstoss- und Ausziehkräfte an rückseitig angebrachten Mehrfachsteckern zu überwinden.

In der WO 96/42187 wird ein Frontsystem für eine Flachbaugruppe mit Aktiv-Passiv-Schaltung gezeigt, welches unabhängig davon, ob eine Verriegelung wirklich eingetreten ist, eine Einfahrstellung der Flachbaugruppe über ein Schaltelement abtastet. Ein unabsichtliches nicht Einrasten einer Verriegelung sowie ein Verschieben des Schaltpunktes in Einschubrichtung können zu Schaltzuständen führen, die im Widerspruch zur mechanischen Situation stehen.

Aufgabe der Erfindung ist es, eine sichere Verriegelung für Baugruppenträger mit Steckbaugruppen zu schaffen. Diese Aufgabe wird dadurch gelöst, dass für den Ein- und Aushebegriff ein zusätzlicher federbetätigter Riegel an der Frontseite angebracht ist, welcher den Hebel zwangsläufig in einer hinteren Endstellung der Steckbaugruppe verriegelt und welcher nach der Entriegelung des Hebels eine Verriegelung des Hebels nur möglich macht, wenn der Hebel mindestens um einen Winkel α ≥ ε in Ausfahrrichtung und wieder zurück in die hintere Endstellung gedreht ist, wobei der Winkel ε eine Überlappung darstellt, mit der der Riegel sich in der Entriegelstellung an einer Führungsfläche des Hebels selbst blockiert, während beim Drehen des Hebels um einen Winkel α ≥ ε und zurück der Riegel durch die Führungsfläche in einer weiteren Entriegelstellung gehalten ist.

Diese Anordnung hat den Vorteil, dass sie die Wirksamkeit der Verriegelung des Ein- und Aushebegriffs überwacht.

Ein weiterer Vorteil besteht darin, dass die räumliche Anordnung von Hebel und Riegel so geschickt vorgenommen ist, dass die räumlichen und schalttechnischen Anforderungen der Normen
- IEEE STANDARD 1101.10
- HOT SWAP SPECIFICATION PICMG 2.1 R1.0
- VME 64 EXTENSIONS STANDARD VITA 1.1-199X, DRAFT 2.0
erfüllbar sind.

Weitere vorteilhafte Ausführungen der Erfindung ergeben sich aus den Merkmalen der abhängigen Ansprüche 2 bis 14. So besteht ein Vorteil, dadurch, dass der Riegel nach dem Erreichen einer wirksamen Verriegelstellung ein Schaltelement für eine Aktivschaltung der Steckbaugruppe betätigt, sowie dass bei einem Niederdrücken des Riegels dieser am Schaltelement eine Passiv-Schaltung bewirkt bevor der Hebel durch den Riegel freigegeben ist.

Damit wird das Schaltelement für die Aktiv-Schaltung erst dann betätigt, wenn eine Verriegelung des Griffhebels stattgefunden hat, und das elektrisch wirkende Schaltelement ist bereits passiv geschaltet, wenn die Verriegelung den Griffhebel freigibt. Ein weiterer Vorteil besteht bei einem unabsichtlichen Niederdrücken der Verriegelung, da zum einen eine Passiv-Schaltung bereits stattgefunden haben muss, wenn sich der Riegel in der entriegelten Stellung hält, und zum anderen eine Mindestdrehung vorwärts und rückwärts des Griffhebels erfolgen muss, bevor überhaupt wieder eine Verriegelung mit anschliessender Aktivierung des Schaltelements erfolgen kann.

Beim Niederdrücken des Riegels blockiert sich dieser aus der verriegelten Stellung in einer entriegelten Stellung ohne aktives Einwirken anderer Elemente und mit der Drehung des Hebels blockiert dieser den Riegel solange in einer Entriegelstellung, bis er mit der Steckbaugruppe die hintere Endstellung wieder erreicht hat. Die eigentliche Verriegelung findet zwangsweise durch eine Feder mit dem Erreichen der hinteren Endstellung statt. Dies hat den Vorteil, dass die Betätigung des Schaltelements immer durch die gleich vorgespannte Feder erfolgt und von der Geschwindigkeit und den Stössen beim Einfahren der Steckbaugruppe unbeeinflusst ist. Dadurch, dass der Riegel unabhängig vom Hebel in einer geraden Führung an der Frontseite der Steckbaugruppe geführt ist, muss der Hebel nicht bewegt werden, um in eine Entriegelstellung zu kommen. Der Hebel kann erst mit Drehen in Ausstossrichtung anfangen, wenn ein Anschlag am Riegel, der entgegen der Drehrichtung des Hebels angeordnet ist, ausgefahren ist.

Ein Schlag auf den verriegelten Hebel verursacht auch kein Prellen am Schaltelement, da der Riegel unabhängig'vom Hebel in der Schaltrichtung des Schaltelements abgestützt ist.

Die Vorteile der mechanischen Verriegelung lassen sich auch ohne elektrisches Schaltelement ausnutzen. So kann ein zweiter gespiegelter Hebel mit Verriegelung am anderen Ende der Frontseite einer Steckbaugruppe angebracht sein, um das Ein- und Aushebeln zu erleichtern und um lediglich eine weitere Verriegelung der Steckbaugruppe im eingefahrenen Zustand zu erreichen. Bei einer solchen Anordnung kann auf eine zusätzliche Verschraubung zwischen Frontplatte und Gehäuseprofil verzichtet werden, sodass am Gehäuseprofil nur vorlaufende Zentrierstifte eingreifen, um Seitenkräfte aufzunehmen.

Dadurch, dass sich mit dem Erreichen der Entriegelstellung ein Überlappungswinkel e zwischen dem Hebel und dem Riegel einstellt, um den der Hebel mindestens gedreht werden muss, bevor wieder eine Verriegelstellung durch Zurückdrehen des Hebels erreicht werden kann, ist es vorteilhaft, wenn der Winkel ϕ für den Flankenwechsel zum Ausstossen grösser als der Überlappungswinkel ε ist. Dies bewirkt, dass die Umkehr vom entriegelten Zustand zum verriegelten Zustand möglich ist, ohne dass eine Bewegung an den rückseitig angebrachten Mehrfachsteckern der Steckbaugruppe stattfindet.

Hebel und Riegel sind so konstruiert, dass sie jeweils im Spritzverfahren in einem Spritzwerkzeug herstellbar sind, wobei die wesentlichen Funktionsmasse für den gegenseitigen Eingriff werkzeuggebundene Masse sind. Entsprechend klein sind die Herstelltoleranzen, was eine grosse Sicherheit für die Funktion bewirkt.

Im folgenden wird die Erfindung anhand von Ausführungsbeispielen beschrieben. Es zeigen:
- Fig. 1: schematisch einen Ausschnitt an der unteren Frontseite einer Steckbaugruppe beim Ausstossen aus dem Gehäuse eines Baugruppenträgers;
- Fig. 2: schematisch einen Schnitt durch eine Anordnung in ausgefahrener Stellung gemäss Fig. 1;
- Fig. 3: schematisch die Anordnung von Fig. 2 in eingefahrener Stellung verriegelt;
- Fig. 4: schematisch die Anordnung von Fig. 3 in eingefahrener Stellung entriegelt;
- Fig. 5: schematisch eine Ansicht einer weiteren Ausführung eines Ein- und Aushebegriffs, dessen Hebelarm in der hinteren Endstellung der Steckbaugruppe parallel zur Frontplatte ausgerichtet ist und ein Fenster aufweist, durch welches Anzeigeelemente in der Frontplatte sichtbar sind; und
- Fig. 6: schematisch eine Seitenansicht der Ausführung von Fig. 5.

In den Figuren ist ein Baugruppenträger mit einer Steckbaugruppe 2 gezeigt, welche mit einem Ein- und Aushebegriff 5 in eine und aus einer hinteren Endstellung 10 beweglich ist. Ein zusätzlicher federbetätigter Riegel 12 an der Frontseite 7, welcher den Ein- und Aushebegriff zwangsläufig in der hinteren Endstellung sichert, betätigt nach dem Erreichen einer wirksamen Verriegelstellung ein Schaltelement 11 für eine Aktiv-Schaltung der Steckbaugruppe. Ein Niederdrücken des Riegels 12 bewirkt im verriegelten Zustand eine Passiv-Schaltung, bevor der Ein- und Aushebegriff 5 nach einem weiteren Stück Verschiebeweg des Riegels entriegelt ist und die Entriegelung im Zusammenwirken mit Riegel 12 mechanisch speichert.

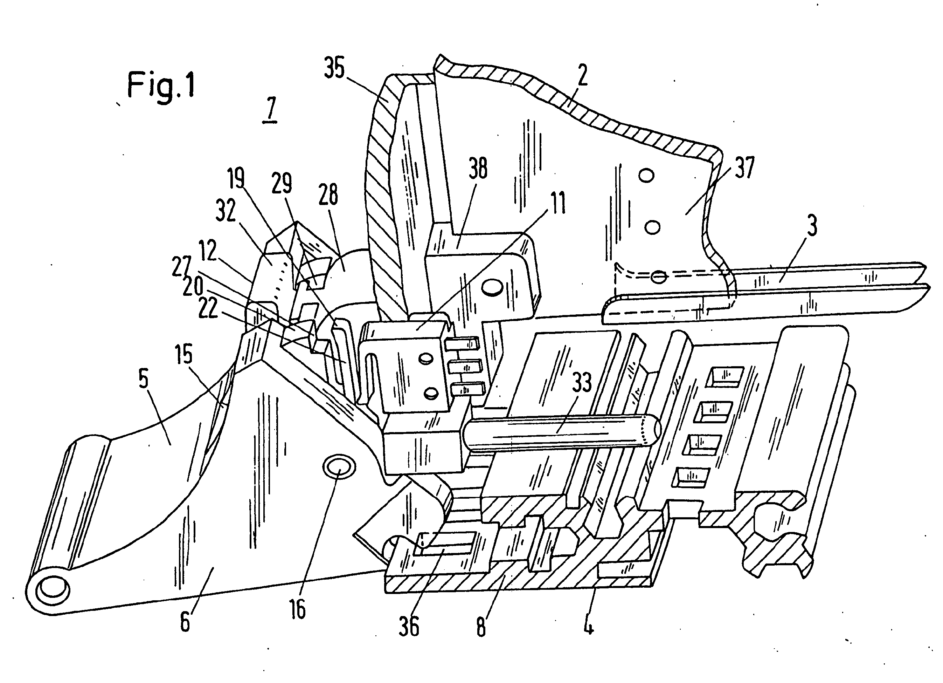

In Fig. 1-ist die Steckbaugruppe 2 an ihrer Frontseite 7 als Printplatte 2 über Befestigungselemente 38 mit einer Frontplatte 35 zusammengesetzt. An der Frontplatte 35 ist ebenfalls am unteren und oberen Ende ein Sockel 28 befestigt, der einen Tragkörper für das Schaltelement 11 sowie für den Hebel 6 über eine Achse 16 bildet. Vor der Achse 16 und parallel zur Frontplatte 35 ist der Sockel 28 zu einem T-förmigen Profil ausgebildet, welches mit seinen Nuten 29 eine vertikale Längsführung für den Riegel 12 bildet, der das T-förmige Profil umgreift. Der Ein- und Aushebegriff 5 ist als Hebel 6 ausgebildet, der mit zwei seitlichen Laschen über die Achse 16 am Sockel 28 drehbar gelagert ist und den Riegel 12 mitsamt dem Sockel weitgehend abdeckt. Am Ein- und Aushebegriff 5 ist eine Ausnehmung 15, durch welche der Riegel 12 mit einem Vorsprung 32 für seine Betätigung herausragt. Am Riegel 12 sind in einer Ebene senkrecht zur Achse 16 funktionale Elemente wie eine Eingriffsfläche 20, ein Anschlag 27 und ein seitlich angeformtes Federelement mit einer Eingriffsfläche 19 gezeigt, die im Zusammenwirken mit dem Hebel 6 das Schaltelement 11 betätigen. Die Steckbaugruppe ist an ihrer Unter- und Oberseite in Führungen 3 am Gehäuse 4 einschiebbar, um auf ihrer Rückseite (hier nicht gezeigt) eine Verbindung über Mehrfachstecker herzustellen. Am Sockel 28 ist ein voreilender Kontaktstift 33 befestigt, um eine Erdung der Steckbaugruppe vor dem Betätigen der Mehrfachstecker zu erreichen. Das Schaltelement 11 ist als Mikroschalter mit Steckkontakten ausgeführt, um es an die Printplatte 37 anschliessen zu können. Das Gehäuse endet zur Frontseite 7 hin als Gehäuseprofil 8 mit Ausnehmungen 36, in welche der Hebel 6 eingreifen kann, um beim Einstossen durch seine Untersetzung die Klemmkräfte an den rückseitigen Mehrfachsteckern leichter zu überwinden.

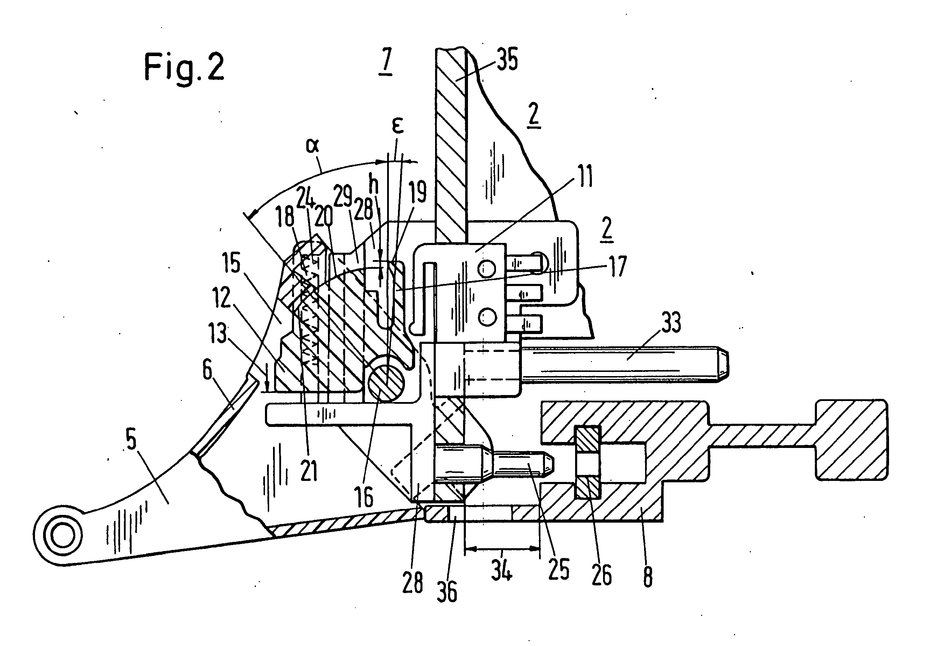

Die weiteren Figuren 2 bis 4 sind mit gleichen Hinweiszeichen versehen und stellen verschiedene Schaltsituationen dar, wobei Riegel 12 und Hebel 6 in der vorher erwähnten Ebene für die funktionalen Elemente geschnitten sind. Die Fig. 2 stellt beim Ausheben der Steckbaugruppe die Stellung dar, in der die Drehung des Hebels 6 um einen Winkel α ein Ausheben um einen Aushebeweg 34 mit einem Betrag von beispielsweise 6,5 mm bewirkt hat, und zur Fortsetzung der Bewegung die Steckbaugruppe an den Hebeln 6 ohne Drehung herausgezogen wird.

In der gleichen Drehwinkelstellung α muss die Steckbaugruppe eingeschoben werden, damit die vorstehenden Nasen vom Hebel 6 in die Ausnehmungen 36 am Gehäuseprofil 8 eintauchen können. In dieser Situation wird der Riegel 12 durch eine Rückstellfeder 24 längs der Führungsnuten 29 nach oben gepresst und liegt mit der kreisförmigen Eingriffsfläche 20 an einer ebenfalls kreisförmigen Führungsfläche 21 des Hebels mit Radius 31 an. Die vertikale Position des Riegels 12 entspricht einer Entriegelstellung 13, die bei einer Drehung des Hebels unverändert bleibt, da beide Kreisflächen 20, 21 in ihrem Zentrum mit dem der Achse 12 zusammenfallen. Bei einem Zurückdrehen des Hebels 6 um den Winkel α wird eine Schrägschulter 18 mit einer Überlappung einer Höhe h, die beispielsweise 1 mm betragen kann, bis zur Berührung an eine Blattfeder 17 herangeführt. In dieser Stellung überdeckt die Führungsfläche 21 immer noch Teile der Eingriffsfläche 20 und verhindert, dass der Riegel 12 von der Rückstellfeder 18 nach oben gestossen wird.

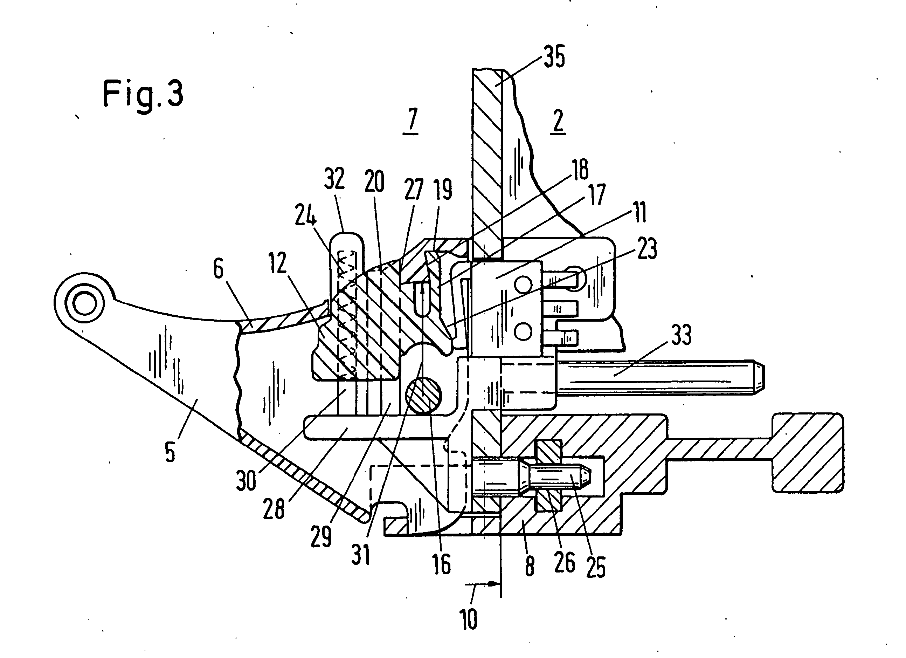

Erst nach dem Weiterdrehen um einen Winkelbetrag ε wird der Riegel 12 freigegeben und gleichzeitig die Blattfeder 17 um diesen Betrag zurückgebogen. Die Rückstellfeder 24 ist so ausgelegt, dass sie die Reibung vom Riegel 12 am Sockel 28 und am Hebel 6 sowie die Schaltkraft von einem Nocken 23 gegen Schaltelement 11 mit Sicherheit überwindet, um in die Stellung entsprechend Fig. 3 zu gelangen. Ein Anschlag 27 am Riegel 12 verhindert, dass sich der Hebel 6 trotz vorgespannter Blattfeder zurückdreht. Der mit der Rückstellfeder ausgelöste Bewegungsablauf sieht zunächst vor, dass der Hebel 6 verriegelt ist, dass anschliessend in einem Sicherheitsabstand der Nocken 23 das Schaltelement betätigt und dass mit dem vollständigen Einfahren des Riegels 12 die Spitze der Blattfeder 17 an der Schrägfläche 18 des Hebels um einen Winkelbetrag ε in ihre entspannte Stellung zurückgleiten kann. Diese in Fig. 3 eingenommene Lage wird zwangsläufig durch die Drehung des Hebels 6 erreicht und entspricht dem Endzustand beim Einfahren der Steckbaugruppe.

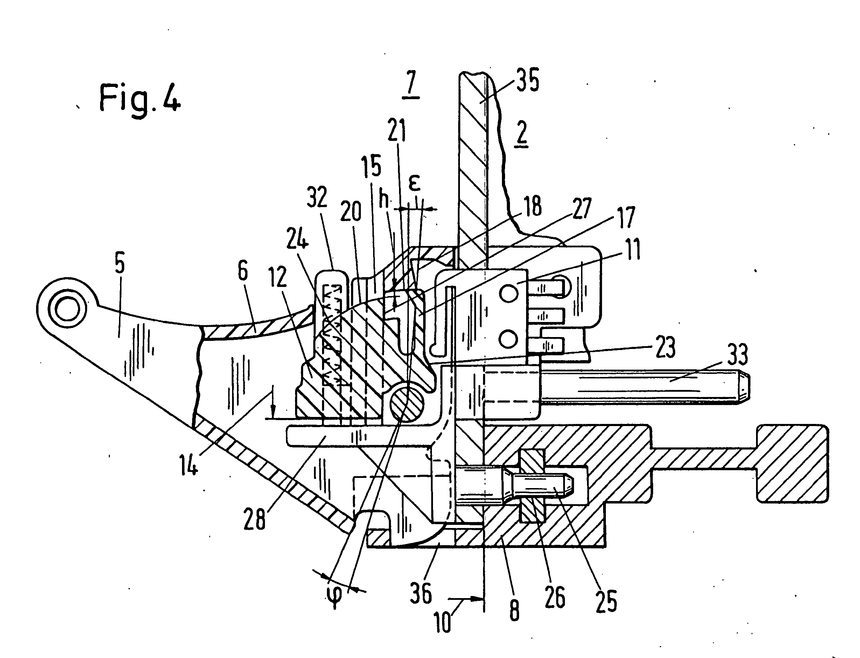

Aus diesem verriegelten Endzustand findet das Ausheben der Steckbaugruppe statt, indem zunächst der Riegel 12 am Vorsprung 32 niedergedrückt wird. Dabei verlässt der abwärtsfahrende Nocken 23 den Mikroschalter und löst das Passiv-Schalten der Steckbaugruppe aus, während eine Drehbewegung des Hebels 6 immer noch durch den Anschlag 27 am Riegel gesperrt ist. Während dem Abwärtsfahren des Riegels 12 wird die Blattfeder um einen Winkelbetrag ε auf der Schrägfläche 18 des Hebels vorgespannt, um den sie zurückfedert, sobald ihre Spitze von der Schrägfläche 18 freigegeben ist. Durch das Zurückfedern stellt sich eine Überlappung zwischen einer Eingriffsfläche 19 und der Führungsfläche 21 ein und es entsteht der entriegelte Zustand von Fig. 4, aus dem heraus der Hebel 6 gedreht werden kann und in dem Mass wie die Überlappung zwischen Eingriffsfläche 19 und Führungsfläche 21 abnimmt eine neue Überlappung zwischen Führungsfläche 21 und Eingriffsfläche 20 aufbaut. Sobald die Eingriffsfläche 19 der Blattfeder verlassen ist, wird der Riegel aus einer Entriegelstellung 14 um das Höhenmass "h" in die Entriegelstellung 13 gestossen, in der sich die kreisförmige Eingriffsfläche 20 und die Führungsfläche 21 berühren. Je weiter die Führungsfläche 21 mit der Drehung des Hebels 6 auf der Eingriffsfläche 20 hinunterrutscht desto grösser ist bei konstanter Federkraft die Normalkraft zwischen diesen beiden Flächen und damit auch die Reibungskraft, sodass der Hebel 6 mit dem Erreichen eines Winkels α wie in Fig. 2 in dieser Winkelstellung durch die grösste Reibungskraft gehalten ist. Dies hat den Vorteil, dass der Hebel 6 auch in einer gespiegelten Anordnung an der oberen Frontseite trotz seines Eigengewichtes nicht herunterfällt, sondern in der durch den Winkel α vorgegebenen Position, die durch das Anschlagen des Hebels 6 am Sockel 28 bestimmt ist, beibehalten werden kann.

Ein weiterer Vorteil besteht darin, dass die Aktiv- oder Passiv-Schaltung der Steckbaugruppe auch äusserlich durch die Verriegelt- oder Entriegelt-Position des Riegels sichtbar ist.

Es versteht sich, dass die hier gezeigte Mechanik der Verriegelung die äusserlich durch die Position des Vorsprungs 32 angezeigt ist auch ohne Schaltelement 11 und allgemein ausserhalb der zitierten Normen für eine visuell oder taktil kontrollierbare Verriegelung verwenden lässt.

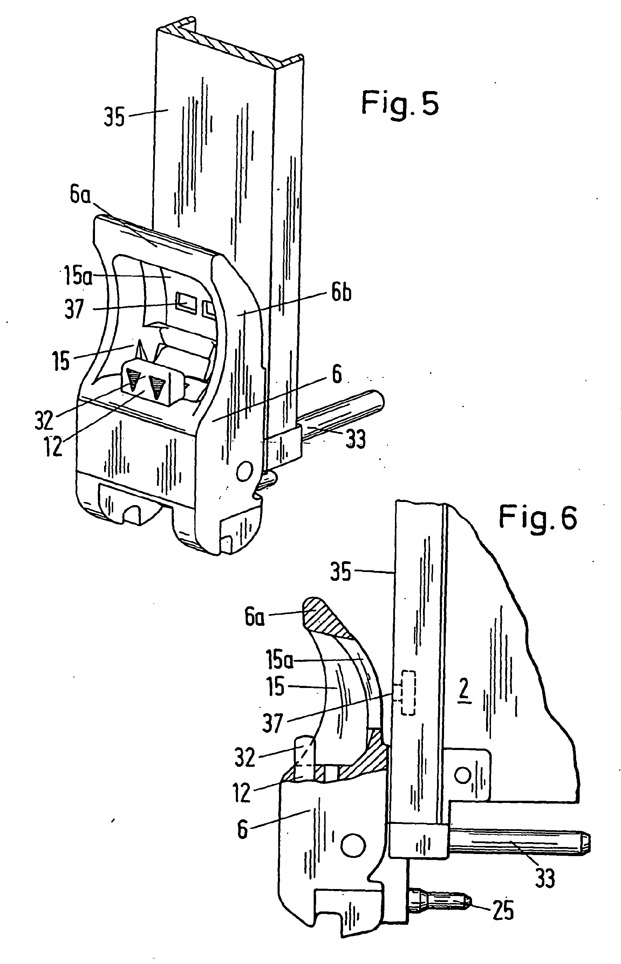

In einer weiteren Ausführung Fig. 5 und Fig. 6 ist der Hebelarm 6 des Ein- und Aushebegriffs 5 so gestaltet, dass der Hebelarm 6 mit dem Erreichen der hinteren Endstellung der Steckbaugruppe parallel zur Frontplatte 35 ausgerichtet ist. Eine Ausnehmung 15, in welche der Riegel 12 mit seinem Vorsprung 32 für seine Betätigung hineinragt, ist in dieser Stellung auf der Vorderseite angebracht. Die Ausnehmung 15 ist so gross bemessen, dass der Vorsprung 32 mit mindestens einer Fingerkuppe zum Entriegeln niedergedrückt werden kann. Diese Anordnung hat den Vorteil, dass der Hebelarm 6 nicht weit vorsteht und dass der Riegel 12 durch den schalenförmig darüberstehenden Hebelarm 6 mechanisch geschützt ist.

Ein weiterer Vorteil, der ganz allgemein für parallel zur Frontplatte ausgerichtete Ein- und Aushebegriffe gilt, besteht darin, dass das ein solcher Hebelarm 6, der zwangsläufig einen Teil der Frontplatte 35 abdeckt, mit einem Fenster 15a versehen wird oder aus einem transparenten Material gefertigt ist, um dahinterliegende Anzeigeelemente 37 in der Frontplatte 35 sichtbar zu machen.

Im vorliegenden Ausführungsbeispiel von Fig. 5 und 6 ist im Hebelarm 6 ein Fenster 15a angebracht, sodass der Hebelarm 6 eigentlich zwei Seitenwangen 6b und eine Traverse 6a aufweist. Durch das Fenster 15a sind Leuchtdioden als Anzeigeelemente 37 auf der Frontplatte 35 sichtbar, die über den Status der Steckbaugruppe 2 Auskunft geben können. Wenn ein solcher Hebelarm 6 mit einem Verriegelungsmechanismus, wie er in dem Beispiel der Figuren 1 bis 4 beschrieben ist, kombiniert wird, dann hat dies auch noch den Vorteil, dass durch das Fenster 15a ein zusätzliches optisches Signal für das unbeschadete Ausfahren der Steckbaugruppe sichtbar gemacht werden kann. Der Ablauf würde dann so ergänzt, dass durch das Niederdrücken des Riegels 12 die Passiv-Schaltung eingeleitet wird und der Hebel zum Aushebeln der Steckbaugruppe freigegeben wird und dass mit dem Erreichen der Passiv-Schaltung ein entsprechendes Signal durch das Fenster sichtbar wird, welches dem Bedienungspersonal signalisiert, wann die Passiv-Schaltung abgeschlossen ist. Dies ist dann von Vorteil, wenn die Passiv-Schaltung längere Zeit beansprucht, weil beispielsweise bestimmte Schaltzustände in der Steckbaugruppe 2 nicht sofort erreicht werden können. Eine weitere Hilfestellung für diesen Fall liegt in der Gestaltung der Abmessungen des Hebelarms 6. Die Aussparung 15 ist so gewählt, dass sie mit mindestens einem Finger die Betätigung vom Riegel 12 gestattet, während auf der Traverse vom Hebel 6 zwei und mehr Finger Platz finden. Eine Bedienungsperson muss mit mindestens einem Finger den Riegel 12 betätigen und-kann während dieser Zeit höchstens einen benachbarten Finger auf der Traverse 6a in einer eher unangenehmen Haltung oder eben gar nicht absetzen. Sobald sie nun in einer Folgebewegung den Entriegelungsfinger und eventuelle weitere auf die Traverse setzt, um die nicht geringen Kontaktkräfte beim Aushebeln zu überwinden, wird das Fenster 15a freigegeben und die Statusanzeige der Passiv-Schaltung sichtbar. Es besteht also allgemein und speziell im Fall einer verzögerten Passiv-Schaltung die Möglichkeit einer Kontrolle vom Status der Steckbaugruppe 2 an dem Ort, an dem die Betätigung für die Trennung für die rückseitigen Kontakte vorgenommen werden soll. Eine weitere Möglichkeit besteht darin, die Aussparung 15 und das Fenster 15a so hoch zu machen, dass die Anzeige 37 über den Entriegelungsfinger weg sichtbar ist.

## Patentansprüche

1. Ein- und Aushebegriff zum Ein- und Aushebeln einer Steckbaugruppe (2) in beziehungsweise aus einem Baugruppenträger, welcher Ein- und Aushebegriff einen Hebelarm (6) mit Ausnehmung (15) und einen Riegel (12) zur Verriegelung des Hebelarms umfasst, derart ausgebildet, dass der Hebelarm in der hinteren Endstellung der Steckbaugruppe (2) parallel zur Frontplatte (35) derselben ausrichtbar ist, **dadurch gekennzeichnet, dass** die Ausnehmung (15) auf der Vorderseite des Hebelarms (6) angebracht ist, dass die Ausnehmung (15) so bemessen und der Riegel (12) derart angeordnet ist, dass in einer Stellung des Hebelarms, die der hinteren Endstellung der Steckbaugruppe (2) entspricht, der Riegel (12) mit einem Betätigungsvorsprung (32) in die Ausnehmung (15) hineinragt und der Betätigungsvorsprung (32) zum Entriegeln mit mindestens einer Fingerkuppe niederdrückbar ist, und dass die Ausnehmung (15) zu einem Fenster (15a) erweitert ist oder der Hebelarm (6) aus einem transparenten Material besteht, um im eingebauten Zustand des Ein-und Aushebegriffs dahinter liegende Anzeigeelemente (37) in der Frontplatte (35) sichtbar zu machen.

2. Ein- und Aushebegriff nach Anspruch 1, wobei die Ausnehmung (15) schalenförmig ausgebildet ist und/oder der Hebelarm (6) zum Ende hin geschlossen ist.

3. Ein- und Aushebegriff nach einem der Ansprüche 1 oder 2, wobei der Hebelarm (6) zwei Seitenwangen (6b) und eine Traverse (6a) aufweist.

4. Ein- und Aushebegriff nach einem der vorangehenden Ansprüche umfassend eine Achse, auf welcher der Hebelarm (6) gelagert ist.

5. Ein- und Aushebegriff nach einem der vorangehenden Ansprüche, wobei der Riegel (12) federbetätigt ausgeführt ist und wobei der Riegel (12) den Ein- und Aushebegriff in einer Stellung, die der hinteren Endstellung der Steckbaugruppe (2) entspricht, zwangsläufig sichert.

6. Ein- und Aushebegriff nach einem der vorangehenden Ansprüche umfassend eine gerade Führung (29), in welcher der Riegel (12) unabhängig vom Hebelarm (6) geführt ist.

7. Ein- und Aushebegriff nach einem der vorangehenden Ansprüche, **dadurch gekennzeichnet, dass** der Riegel (12) nach der Entriegelung des Hebelarms (6) eine Verriegelung des Hebelarms nur möglich macht, wenn der Hebelarm (6) mindestens um einen Winkel α ≥ ε in Ausfahrrichtung und wieder zurück in die hintere Endstellung (10) gedreht ist, wobei der Winkel ε eine Überlappung darstellt, mit welcher der Riegel (12) sich in der Entriegelstellung (14) an einer Führungsfläche (21) des Hebelarms (6) selbst blockiert, während beim Drehen des Hebelarms (6) um einen Winkel α ≥ ε und zurück der Riegel (12) durch die Führungsfläche (21) in einer weiteren Entriegelstellung (13) gehalten ist.

8. Ein- und Aushebegriff nach einem der vorangehenden Ansprüche, **dadurch gekennzeichnet, dass** die Verriegelung äusserlich durch die Position des Vorsprungs 32 angezeigt ist.

9. Ein- und Aushebegriff nach einem der vorangehenden Ansprüche, wobei die Höhe der Aussparung (15) und des Fensters (15a) derart ausgebildet ist, dass im eingebauten Zustand des Ein- und Aushebegriffs dahinter liegende Anzeigeelemente (37) in der Frontplatte (35) über den Entriegelungsfinger weg sichtbar sind.

10. Ein- und Aushebegriff nach einem der vorangehenden Ansprüche, derart für eine Aktiv-Passiv-Schaltung der Steckbaugruppe (2) ausgebildet, dass nach dem Erreichen einer wirksamen Verriegelstellung des Riegels (12) mittels diesem ein Schaltelement (11) für eine Aktivschaltung der Steckbaugruppe betätigbar ist, sowie dass bei einem Niederdrücken des Riegels (12) mittels diesem am Schaltelement (11) eine Passiv-Schaltung bewirkbar ist, bevor der Hebelarm (6) durch den Riegel freigegeben ist.

11. Ein- und Aushebegriff nach einem der vorangehenden Ansprüche, wobei Hebelarm (6) und Riegel (12) jeweils in einer Spritzform hergestellt sind, um die Streuung der Funktionsmasse für Verriegelung und Entriegelung klein zu halten.

12. Steckbaugruppe, **dadurch gekennzeichnet, dass** die Steckbaugruppe auf ihrer Frontseite mit mindestens einem Ein- und Aushebegriff nach einem der vorangehenden Ansprüche versehen ist.

13. Steckbaugruppe nach Anspruch 13 umfassend eine Aktiv-Passiv-Schaltung, wobei die Steckbaugruppe insbesondere derart ausgebildet ist, dass der Riegel (12) nach dem Erreichen einer wirksamen Verriegelstellung ein Schaltelement (11) für eine Aktivschaltung der Steckbaugruppe betätigt, sowie dass bei einem Niederdrücken des Riegels (12) dieser am Schaltelement (11) eine Passiv-Schaltung bewirkt, bevor der Hebelarm (6) durch den Riegel freigegeben ist.

14. Steckbaugruppe nach einem der Ansprüche 13 oder 14 umfassend eine Statusanzeige (37) für die Passiv-Schaltung der Steckbaugruppe, wobei die Statusanzeige hinter dem verriegelten Hebelarm (6) angebracht ist und der Hebelarm ein Fenster (15a) aufweist oder transparent ist, damit die Statusanzeige (37) von vorne ablesbar ist.

15. Baugruppenträger, **dadurch gekennzeichnet, dass** der Baugruppenträger mindestens eine Steckbaugruppe nach einem der Ansprüche 13 bis 15 umfasst.

## Claims

1. An insertion and removal handle for the respective levering in and levering out of a plug module (2) into or out of a module carrier, said insertion and removal handle, which includes a lever arm (6) with a cut-out (15) and a bolt (12) for the latching of the lever arm, being formed such that the lever arm can be aligned in the rear end position of the plug module (2) parallel to the front plate (35) of the same, **characterised in that** the cut-out (15) is provided at the front side of the lever arm (6), **in that** the cut-out (15) is so dimensioned and the bolt (12) is so arranged that in a position of the lever arm which corresponds to the rear end position of the plug module (2) an actuating projection (32) of the bolt (12) projects into the cut-out (15) and the actuating projection (32) can be pressed down with at least one finger tip for the delatching and **in that** the cut-out (15) is broadened into a window (15a), or the lever arm (6) consists of a transparent material in order, in the installed state of the insertion and removal handle, to make display elements (37) in the front plate (35) lying behind it visible.

2. An insertion and removal handle in accordance with one of the claim 1, wherein the cut-out (15) is of shell-like form and/or the lever arm (6) is closed towards the end.

3. An insertion and removal handle in accordance with any of the claims 1 or 2, wherein the lever arm (6) has two side cheeks (6b) and a transverse portion (6a).

4. An insertion and removal handle in accordance with any one of the preceding claims, comprising an axle on which the lever arm (6) is journalled.

5. An insertion and removal handle in accordance with any one of the preceding claims, wherein the bolt (12) is made spring-actuated and wherein the bolt (12) compulsorily secures the insertion and removal handle in a position which corresponds to the rear end position of the plug module (2).

6. An insertion and removal handle in accordance with any one of the preceding claims, including a straight guide (29) in which the bolt (12) is guided independently of the lever arm (6).

7. An insertion and removal handle in accordance with any one of the preceding claims, **characterised in that** the bolt (12) only makes a latching of the lever arm possible following delatching of the lever arm (6) when the lever arm (6) is turned at least through an angle α ≥ ε in the removal direction and back again into the rear end position (10), with the angle ε representing an overlap with which the bolt (12) blocks itself at a guide surface (21) of the lever arm (6) in the delatched position (14) whereas, on turning the lever arm (6) through an angle α ≥ ε and back, the bolt (12) is held by the guide surface (21) in a further delatched position (13).

8. An insertion and removal handle in accordance with any one of the preceding claims, **characterised in that** the latching is externally indicated by the position of the projection (32).

9. An insertion and removal handle in accordance with any one of the preceding claims, wherein the height of the cut-out (15) and of the window (15a) is made such that in the installed state of the insertion and removal handle display elements (37) in the front plate (35), which lie behind the insertion and removal handle, are visible beyond the delatching finger.

10. An insertion and removal handle in accordance with any one of the preceding claims and constructed for an active-passive switching of the plug module (2) in such a way that after achieving an effective latched position of the bolt (12) a switch element (11) for active switching of the plug module can be actuated by means of the bolt (12) and also in that on depressing the bolt (12) a passive switching can be brought about by means of it at the switching element (11) before the lever arm (6) is released by the bolt.

11. An insertion and removal handle in accordance with any one of the preceding claims, wherein the lever arm (6) and the bolt (12) are each manufactured in an injection mould in order to keep the scatter of the functional measures for the latching and unlatching small.

12. A plug module, **characterised in that** the plug module is provided at its front side with at least one insertion and removal lever in accordance with any one of the preceding claims.

13. A plug module in accordance with claim 12, including an active-passive switching circuit, wherein the plug module is in particular constructed such that the bolt (12), after reaching an active latching position, actuates a switch element (11) for an active switching of the plug module and also in that on depressing the bolt (12) the latter brings about a passive switching at the switching element (11) before the lever arm (6) is released by the bolt.

14. A plug module in accordance with one of the claims 12 or 13, including a status display (37) for the passive switching of the plug module, with the status display being provided behind the latched lever arm (6) and the lever arm having a window (15a) or being transparent so that the status display (37) can be read off from the front.

15. A module carrier, **characterised in that** the module carrier includes at least one plug module in accordance with any one of the claims 12 to 14.

## Revendications

1. Prise d'introduction et de dégagement pour introduire et sortir par effet de levier une unité enfichable (2) dans ou hors d'un support d'unité, laquelle prise d'introduction et de dégagement comprend un bras de levier (6) avec évidement (15) et un verrou (12) pour le verrouillage du bras de levier, réalisée de telle sorte que le bras de levier est orientable dans la position extrême arrière de l'unité enfichable (2) parallèlement à la plaque frontale (35) de celle-ci, **caractérisée en ce** l'évidement (15) est placé sur le côté avant du bras de levier (6) de telle sorte que l'évidement (15) est dimensionné et le verrou (12) est disposé de telle sorte que, dans une position du bras de levier qui correspond à la position extrême arrière de l'unité enfichable (2), le verrou (12) dépasse avec une saillie d'actionnement (32) dans l'évidement (15) et la saillie d'actionnement (32) peut être appuyée avec au moins un bout de doigt pour le déverrouillage et en que l'évidement (15) est élargi pour former une fenêtre (15a) ou bien le bras de levier (6) est dans un matériau transparent pour que des éléments d'indication (37) soient visibles dans la plaque frontale lorsque la prise d'introduction et de dégagement est installée.

2. Prise d'introduction et de dégagement selon la revendication 1, sur laquelle l'évidement (15) est conçu en forme de coque et/ou le bras de levier (6) est fermé en direction de l'extrémité.

3. Prise d'introduction et de dégagement selon l'une quelconque des revendications 1 ou 2, sur laquelle le bras de levier (6) présentant deux joues latérales (6b) et une traverse (6a).

4. Prise d'introduction et de dégagement selon l'une quelconque des revendications précédentes, comprenant un axe, sur lequel le bras de levier est fixé.

5. Prise d'introduction et de dégagement selon l'une quelconque des revendications précédentes, sur laquelle le verrou (12) est réalisé actionné par le ressort et le verrou (12) bloque de force la prise d'introduction et de dégagement dans une position qui correspond à la position extrême arrière de l'unité enfichable (2).

6. Prise d'introduction et de dégagement selon l'une quelconque des revendications précédentes, comprenant un guidage (29) droit, dans lequel le verrou (12) est guidé indépendamment du bras de levier (6).

7. Prise d'introduction et de dégagement selon l'une quelconque des revendications précédentes, **caractérisé en ce que**, après le déverrouillage du bras de levier (6), le verrou (12) rend un verrouillage du bras de levier possible seulement lorsque le bras de levier (6) est tourné d'au moins un angle α ≥ ε dans la direction de sortie et de nouveau en arrière dans la position extrême (10) arrière, l'angle ε représentant un chevauchement au moyen duquel le verrou (12) se bloque lui-même dans la position de déverrouillage (14) sur une face de guidage (21) du bras de levier (6), tandis que, lors de la rotation du bras de levier (6) d'un angle α ≥ ε et retour, le verrou (12) est retenu par la face de guidage (21) dans une autre position de déverrouillage (13).

8. Prise d'introduction et de dégagement selon l'une quelconque des revendications précédentes, **caractérisé en ce que** le verrouillage est indiqué extérieurement par la position de la saillie 32.

9. Prise d'introduction et de dégagement selon l'une quelconque des revendications précédentes, la hauteur de l'évidement (15) et de la fenêtre (15a) étant conçue de telle sorte que, lorsque la prise d'introduction et de dégagement est monté, les éléments d'indication (37) se trouvant derrière sont visibles dans la plaque avant (35) au-delà du doigt de déverrouillage.

10. Prise d'introduction et de dégagement selon l'une quelconque des revendications précédentes, conçue pour une commutation active-passive de l'unité enfichable (2) de telle sorte que, après l'atteinte d'une position de verrouillage efficace du verrou (12), un élément de commutation (11) peut être actionné au moyen de ce verrou pour une commutation active de l'unité enfichable, et que, lors d'un appui du verrou (12), une commutation passive peut être réalisée au moyen de ce verrou sur l'élément de commutation (11), avant que le bras de levier (6) soit libérée par le verrou.

11. Prise d'introduction et de dégagement selon l'une quelconque des revendications précédentes, sur laquelle le bras de levier (6) et le verrou (12) sont fabriqués à chaque fois dans un moule afin de maintenir la dispersion de masse fonctionnelle pour le verrouillage et le déverrouillage à un niveau réduit.

12. Unité enfichable, **caractérisée en ce que** l'unité enfichable est dotée sur sa face avant d'au moins une prise d'introduction et de dégagement selon l'une quelconque des revendications précédentes.

13. Unité enfichable selon la revendication 13, comprenant une commutation active-passive, l'unité enfichable étant réalisée en particulier de telle sorte que le verrou (12), après l'atteinte d'une position de verrouillage efficace, actionne un élément de commutation (11) pour une commutation active de l'unité enfichable, et que, lors d'un enfoncement du verrou (12), celui-ci provoque une commutation passive sur l'élément de commutation (11) avant que le bras de levier (6) ne soit libéré par le verrou.

14. Unité enfichable selon l'une quelconque des revendications 13 ou 14, comprenant une indication d'état (37) pour la commutation passive de l'unité enfichable, l'indication d'état étant placée derrière le bras de levier (6) verrouillé et le bras de levier présentant une fenêtre (15a) ou étant transparent pour que l'indication de l'état (37) soit lisible de l'avant.

15. Support d'unité, **caractérisé en ce que** le support d'unité comprend au moins une unité enfichable selon l'une quelconque des revendications 13 à 15.
